# EUROPÄISCHE PATENTANMELDUNG

(11) **EP 1 617 562 A2**
(43) Veröffentlichungstag der Anmeldung: **18.01.2006**
(21) Anmeldenummer: 05011777.9
(22) Anmeldetag: 01.06.2005
(51) Int. Cl.: H03K 17/94

(54) **Oszillatorschaltung**

(30) Priorität: 14.07.2004 DE 102004034190
(71) Anmelder: i f m electronic gmbh, D-45127 Essen (DE)
(72) Erfinder: Sauter, Melnrad, 88099 Neukirch (DE); Lamarche, Jean-Luc, 67206 Mittelausbergen (FR)
(74) Vertreter: Gesthuysen, von Rohr & Eggert

(57) **Zusammenfassung**

Beschrieben und dargestellt ist eine Oszillatorschaltung für einen Sensor, mit einem Schwingkreis (2) und einem Operationsverstärker (3), wobei die elektrische Schwingung des Schwingkreises (2) zwischen einem ersten Anschluß (4) und einem zweiten Anschluß (5) des Schwingkreises (2) abgreifbar ist und der erste Anschluß (4) des Schwingkreises (2) mit dem nichtinvertierenden Eingang des Operationsverstärkers (3) verbunden ist und der Ausgang (6) des Operationsverstärkers (3) auf den nichtinvertierenden Eingang des Operationsverstärkers rückgekoppelt ist.

Der erfindungsgemäßen Oszillatorschaltung liegt die Aufgabe zugrunde, das dynamische Verhalten der Oszillatorschaltung zu verbessern.

Die erfindungsgemäße Oszillatorschaltung löst das Problem dadurch, daß der zweite Anschluß (5) des Schwingkreises (2) - zumindest wechselspannungsmäßig - mit dem invertierenden Eingang des Operationsverstärkers (3) direkt verbunden ist.

## Beschreibung

Die Erfindung betrifft eine Oszillatorschaltung für einen Sensor, mit einem Schwingkreis und einem Operationsverstärker, wobei die elektrische Schwingung des Schwingkreises zwischen einem ersten Anschluß und einem zweiten Anschluß des Schwingkreises abgreifbar ist und der erste Anschluß des Schwingkreises mit dem nichtinvertierenden Eingang des Operationsverstärkers verbunden ist und der Ausgang des Operationsverstärkers auf den nichtinvertierenden Eingang des Operationsverstärkers rückgekoppelt ist.

Oszillatorschaltungen der hier in Rede stehenden Art sind in verschiedenen Ausführungsformen seit längerem bekannt und werden überall dort in der Schaltungstechnik eingesetzt, wo elektrische Schwingungen - meist periodische Verläufe von elektrischen Spannungen - verwendet werden, und beispielsweise als Taktgeber für eine Schaltung, als Träger von Informationen oder als periodische Testsignale dienen.

Ein verbreiteter Anwendungsfall für derartige Oszillatorschaltungen ist der Einsatz in kontaktlos arbeitenden Sensoren, z. B. bei Meßgeräten und Näherungsschaltern mit induktivem, kapazitivem und/oder resistivem Sensorelement. Die Notwendigkeit des Einsatzes von Oszillatoren beruht hier auf dem Effekt, daß sich die durch einen Schwingkreis bewirkte elektrische Schwingung bei Änderung bestimmter, von außen beeinflußbarer Kenngrößen des Schwingkreises ebenfalls ändert und diese Änderung der Schwingung für eine weitere Auswertung genutzt werden kann.

Im folgenden wird der übliche Einsatz einer Oszillatorschaltung am Beispiel eines induktiven Näherungssensors erläutert; analoge Effekte lassen sich jedoch genauso bei kapazitiven oder resistiven Sensoren bzw. Sensorelementen beobachten.

Oszillatorschaltungen weisen üblicherweise einen Schwingkreis, wie beispielsweise einen harmonischen Schwingkreis in Form eines LRC-Netzwerkes auf. Die elektrische Schwingung des Schwingkreises wird nun üblicherweise mittels einer Verstärkerschaltung verstärkt und wieder auf den Schwingkreis zurückgekoppelt, so daß der Schwingkreis unter bestimmten Bedingungen zu einer Dauerschwingung neigt. Bei berührungslos arbeitenden Sensoren ist entweder der Kondensator oder die Spule des Schwingkreises so ausgebildet, daß die Kapazität des Kondensators bzw. die Güte der Spule leicht beeinflußbar ist, indem ein leitender Gegenstand, z.B. ein Metallteil, an den jeweiligen Sensor angenähert wird. Im Falle des induktiv arbeitenden Sensors bewirkt die Annäherung eines leitfähigen Gegenstandes an den Sensor, daß das Streufeld der Spule des Schwingkreises in dem leitfähigen Gegenstand einen Wirbelstrom induziert, der dem elektromagnetischen Feld der Spule Energie entzieht und somit den Schwingkreis dämpft. Die daraus resultierende Amplitudenänderung der elektrischen Schwingung des Schwingkreises ist somit ein lndikator für die Änderung der Güte des Schwingkreises und sie ist mittelbar ein Maß für die Annäherung des leitfähigen Gegenstandes an den Sensor selbst. Die Dämpfung des Schwingkreises führt bei der hier in Rede stehenden, einfachen Oszillatorscbaltung dazu, daß die elektrische Schwingung des Schwingkreises vollständig zum Erliegen kommt Aufbau und Funktionsweise des beschriebenen induktiven Sensors ist bekannt und in der industriellen Anwendung weit verbreitet (Schiff, A.: "Induktive und kapazitive Sensoren", Die Bibliothek der Technik, Band 24, Verlag Moderne Industrie, 1989; Tietze, U.; Schenk Ch.: "Halbleiter-Schaltungs-technik", 12. Auflage, Springer Verlag, 2002, Seite 874).

Bekanntermaßen kommt eine Dauerschwingung nur dann zustande, wenn das rückgekoppelte Signal die Amplitude des Eingangssignals aufweist, d. h. wenn der Verstärker mögliche Übertragungsverluste kompensiert und wenn das mitgekoppelte Signal - im Falle der Mitkopplung - in Phase mit dem Eingangssignal ist, bzw. - im Fall der Gegenkopplung - zu diesem Signal 180° phasenverschoben ist. Durch die beschriebenen Wirbelstromverluste wird die Gesamtverstärkung der Oszillatorschaltung reduziert, wodurch letztendlich für den Fall, daß sich der leitende Gegenstand im Einflußgebiet des elektromagnetischen Streufeldes befindet, die Schwingbedingung für den Schwingkreis nicht mehr erfüllt ist und deshalb die elektrische Schwingung zum Erliegen kommt.

Die hier beschriebene und auch in Abwandlungen bekannte Oszillatorschaltung weist an sich, speziell aber auch im Zusammenhang mit den beschriebenen Sensoren einige Nachteile auf. Ein Nachteil ist in dem unvermeidlichen Abriß der elektrischen Schwingung der Oszillatorschaltung zu sehen. Da Oszillatoren um von einem nicht schwingenden Zustand in einen schwingenden Zustand zu gelangen eine bestimmte Anschwingzeit benötigen, ist ein solcher Sensor bzw. die elektrische Schwingung der in ihm verwendeten Oszillatorschaltung nicht dazu geeignet, jederzeit seinen tatsächlichen Beeinflussungszustand mitzuteilen. Der Sensor ist also für eine gewisse Zeit nicht korrekt einsatzfähig, was insbesondere dann eine erhebliche Einschränkung für die Einsatzfähigkeit eines solchen induktiven Sensors bedeutet, wenn beispielsweise schnelle Bewegungen von Gegenständen, z. B. bei einem Zählvorgang, erkannt werden müssen.

Der Lehre der vorliegenden Erfindung liegt daher das Problem zugrunde, eine Oszillatorschaltung für einen Sensor so auszugestalten und weiterzubilden, daß mit dem Sensor eine schnelle Erfassung und Ausgabe sich ändernder Beeinflussungszustände des Sensors möglich sind.

Die erfindungsgemäße Oszillatorschaltung, bei der die zuvor hergeleitete und aufgezeigte Problemstellung gelöst ist, ist zunächst und im wesentlichen dadurch gekennzeichnet, daß der zweite Anschluß des Schwingkreises - zumindest wechselspannungsmäßig - mit dem invertierenden Eingang des Operationsverstärkers direkt verbunden ist. Durch diese besondere Zusammenschaltung von Schwingkreis einerseits und Operationsverstärker andererseits wird erreicht, daß der Operationsverstärker nicht mehr in einer Verstärkerschaltung betrieben wird, in der also der Ausgang des Operationsverstärkers mittels eines Spannungsteilers auf den invertierenden Eingang des Operationsverstärkers rückgekoppelt wird (Gegenkopplung des Ausgangssignals), sondern er wird in einer Komparatorschaltung, bei der die Polarität der Eingangsspannung an dem invertierenden und nichtinvertierenden Eingang des Operationsverstärkers über das schlagartige Umschalten der Spannung am Ausgang des Operationsverstärkers entscheidet.

Die erfindungsgemäße Oszillatorschaltung ist in vielfacher Weise vorteilhaft. Zum einen kann aufgrund der fehlenden Gegenkopplung des Operationsverstärkers die volle Verstärkung des Operationsverstärkers genutzt werden, weshalb bereits eine äußerst geringe Spannungsdifferenz an den Eingängen des Operationsverstärkers zu einem schnellen Umschalten des mitgekoppelten Ausgangssignals führt, das in erster Näherung bei einem Vorzeichenwechsel der Eingangsspannung des Operationsverstärkers nahezu unverzögert zwischen minimaler und maximaler Ausgangsspannung wechselt. Begrenzt wird die Umschaltgeschwindigkeit lediglich durch die sogenannte Slew Rate.

Ein weiterer Vorteil der erfindungsgemäßen Oszillatorschaltung besteht darin, daß die elektrische Schwingung des Schwingkreises im Gegensatz zu den aus dem Stand der Technik bekannten Beispielen auch durch eine noch so große Dämpfung nicht unterdrückt werden kann. Dies bewirkt, daß jeder Beeinflussungszustand der Oszillatorschaltung anhand der elektrischen Schwingung des Schwingkreises erkennbar ist; es gibt also keine Beeinflussungsbereiche, die nicht voneinander unterscheidbar sind. Gleichzeitig bedeutet dies aber auch, daß der nachteilige Effekt der Anschwingzeit von aus dem Stand der Technik bekannten Oszillatorschaltungen bei der erfindungsgemäßen Oszillatorschaltung nicht mehr auftreten kann, da das ständige Vorhandensein einer elektrischen Schwingung des Schwingkreises gewährleistet ist.

Es gibt eine Vielzahl von Möglichkeiten, die Lehre der Erfindung auszugestalten und weiterzubilden. Dazu wird auf die Unteransprüche verwiesen. Zu besonderen Ausgestaltungen der Erfindung sind folgende Bemerkungen angezeigt.

Die erfindungsgemäße Oszillatorschaltung läßt sich hinsichtlich ihres dynamischen Verhaltens noch weiter verbessern, indem in einem bevorzugten Ausführungsbeispiel anstelle eines "normalen" Operationsverstärker ein Operationsverstärker verwendet wird, der nicht frequenzgang-korrigiert ist und daher als spezieller Komparatorverstärker anzusehen ist. Normale Operationsverstärker, die also hauptsächlich als Verstärker mit einer Gegenkopplung des Ausgangssignals eingesetzt werden, verfügen in der Regel über eine interne Korrektur des Frequenzgangs. Das bedeutet, daß entweder die Amplitudenkennlinie des Operationsverstärkers im Bereich großer Frequenzen abgesenkt wird, oder daß die Phasenkennlinie eines Operationsverstärkers für hohe Frequenzen angehoben wird, um die Phasenreserve des Operationsverstärkers zu erhöhen und damit seine Schwingneigung für den Anwendungsfall als Verstärker zu vermindern. Aufgrund des Fehlens dieser Korrektur verbessert sich die Flankensteilheit bei speziellen Komparatorverstärkern (Slew Rate) gegenüber herkömmlichen - frequenzgang-korrigierten - Operationsverstärkern ganz erheblich; umgekehrt lassen sich die vorteilhaften - weil schaltschnelleren - Komparatorverstärker jedoch nicht mit den Oszillatorsclialtungen verwenden, die aus dem Stand der Technik bekannt sind.

Eine weitere Lehre der Erfindung, der besondere Bedeutung zukommt, ist dadurch gekennzeichnet, daß die Oszillatorschaltung mit einer "Anschwinghilfe" ausgestattet ist. Anschwinghilfe bedeutet hier nicht, daß die elektrische Schwingung der erfindungsgemäßen Oszillatorschaltung während des normalen Betriebes der Schaltung zum Erliegen kommen könnte und die Schaltung deshalb einer besonderen Starthilfe bedürfte, um die elektrische Schwingung wieder zu erregen. Vielmehr bedeutet es hier, daß sich die Schaltung bei Inbetriebnahme in einem Zustand befinden kann, was noch weiter unten näher erläutert werden wird, der ein erstmaliges Anschwingen der erfindungsgemäßen Oszillatorschaltung verhindert. Dieser Zustand wird dadurch vermieden, daß zwischen dem Ausgang des Operationsverstärkers und dem zweiten Anschluß des Schwingkreises ein ohmscher Spannungsteiler vorgesehen ist, und der Mittelabgriff des Spannungsteilers mit dem invertierenden Eingang des Operationsverstärkers verbunden ist. Damit dieser Spannungsteiler während des Normalbetriebs der Oszillatorschaltung nicht als Gegenkopplung wirkt, die nach der Lehre der Erfindung zu vermeiden ist, wird der Zweig des Spannungsteiles zwischen dem Mittelabgriff und dem zweiten Anschluß des Schwingkreises über einen Kondensator wechselstrommäßig kurzgeschlossen.

Selbstverständlich läßt sich die hier beschriebene Oszillatorschaltung nicht nur im Zusammenhang mit einem Sensor einsetzen, sondern auch unabhängig von diesem Anwendungsgebiet im Rahmen jeder anderen schaltungstechnischen Aufgabe verwenden, in der Oszillatoren eine Rolle spielen.

Im einzelnen gibt es nun verschiedene Möglichkeiten, die erfindungsgemäße Oszillatorschaltung auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung zeigen
- Fig. 1: ein bevorzugtes Ausführungsbeispiel der erfindungsgemäßen Oszillatorschaltung,
- Fig. 2: ein bevorzugtes Ausführungsbeispiel der erfindungsgemäßen Oszillatorschaltung mit Stromquelle,
- Fig. 3: ein bevorzugtes Ausführungsbeispiel der erfindungsgemäßen Oszillatorschaltung mit Anschwinghilfe,
- Fig. 4: ein bevorzugtes Ausführungsbeispiel einer erfindungsgemäßen Oszillatorschaltung mit einer nachgeschalteten Demodulatorschaltung und
- Fig. 5: ein Ausführungsbeispiel einer aus dem Stand der Technik bekannten Oszillatorschaltung.

Im folgenden wird die erfindungsgemäße Oszillatorschaltung anhand eines bevorzugten Ausführungsbeispiels eines induktiven Sensors beschrieben. Genauso gut könnte die Erfindung auch anhand einer beliebigen anderen Sensorschaltung beschrieben werden, wie z. B. anhand eines kapazitiven Sensors, der den Einsatz einer Oszillatvrschaltung erfordert. Ganz allgemein ist also die einzige Voraussetzung für die Verwirklichung der Erfindung lediglich die Notwendigkeit des Einsatzes eines Oszillatorschaltung, unabhängig von dem Zweck, den sie in einer übergeordneten Schaltung erfüllt.

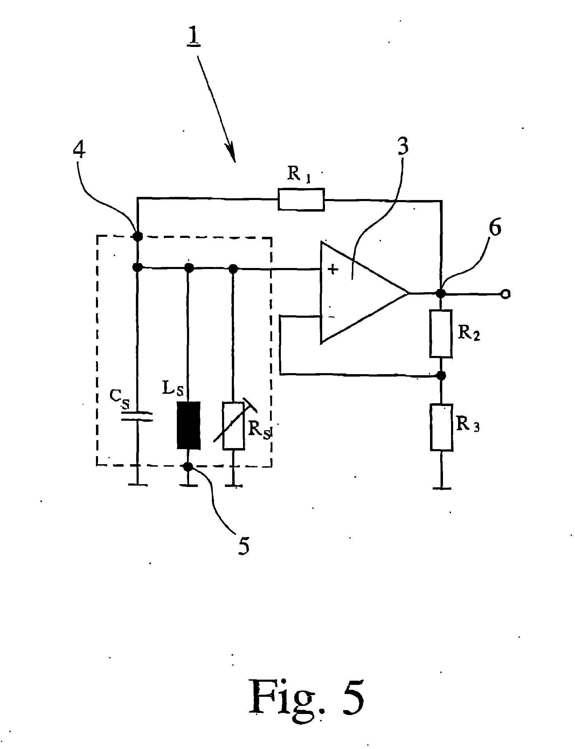

Das Ausführungsbeispiel in Fig. 5 zeigt eine Oszillatorschaltung 1, die aus dem Stand der Technik bekannt ist und von der die Erfindung ausgeht. Die Oszillatorschaltung 1 umfaßt einen Schwingkreis 2 und einen Operationsverstärker 3. Der Schwingkreis 2 ist in diesem Fall als harmonischer Parallelschwingkreis mit einem Kondensator mit der Kapazität C_{S}, einer Spule mit der Induktivität Lₛ und einem Widerstand Rₛ ausgestaltet. Ein erster Anschluß 4 des Schwingkreises 2 ist dabei mit dem nichtinvertierenden Eingang des Operationsverstärkers 3 verbunden und der Ausgang 6 des Operationsverstärkers 3 ist - in Abweichung von der erfindungsgemäßen Ausgestaltung einer Oszillatorschaltung - über einen Spannungsteiler R₂, R₃ mit dem invertierenden Eingang des Operationsverstärkers 3 verbunden, d. h. der Operationsverstärker 3 wird aufgrund der Gegenkopplung des Ausgangs 6 in einer Verstärkerschaltung betrieben. Der zweite Anschluß 5 des Schwingkreises 2 ist in Fig. 5 mit einem festen Bezugspotential verbunden, das jedoch von dem Potential abweicht, das an dem nichtinvertierenden Eingang des Operationsverstärkers 3 anliegt. Ferner ist der Ausgang 6 des Operationsverstärkers 3 über einen Widerstand R₁ mit dem ersten Anschluß 4 des Schwingkreises 2 verbunden, so daß die Oszillatorschaltung nach Fig. 5 ebenfalls selbsterregend ist. Der letztendlich für die Dämpfung des Systems auch verantwortliche Widerstand R_{S} des Schwingkreises 2 wird dabei meist nicht als separates Bauteil vorgesehen, sondern er ergibt sich durch die unvermeidbaren Verlustanteile des LC-Schwingkreises L_{S} C_{S}.

Wie leicht einzusehen ist, kann die Oszillatorschaltung 1 nach Fig. 5 nur dann eine elektrische Schwingung ausbilden, wenn die Spannung am nichtinvertierenden Eingang des Operationsverstärkers 3 größer ist als die Spannung am invertierenden Eingang des Operationsverstärkers 3, wenn also die Bedingung erfüllt ist, daß das Verhältnis von R₁ zu R₂ kleiner oder zumindest gleich ist dem Verhältnis von R₂ zu R₃. Ist diese Bedingung nicht erfüllt, weil beispielsweise im Falle eines induktiven Sensors die Dämpfung des Schwingkreises 2 aufgrund der Wirbelstromverluste in einem hier nicht dargestellten leitenden Gegenstand im Einflußbereich der Spule L₅ angestiegen sind und damit zu einer Verringerung des Widerstands R₅ geführt haben, dann wird die Schwingung des Schwingkreises 2 vollständig zum Erliegen kommen. Dies hat den schon weiter oben beschriebenen Nachteil, daß aufgrund der unvermeidbaren Anschwingzeit der Oszillatorschaltung 1 eine Verzögerung der Bereitschaft der Oszillatorschaltung 1 und damit des induktiven Sensors in Kauf genommen werden muß, die es nicht gestattet, ihn in Anwendungen mit hohen dynamischen Anforderungen einzusetzen (hochfrequente Zählvorgänge).

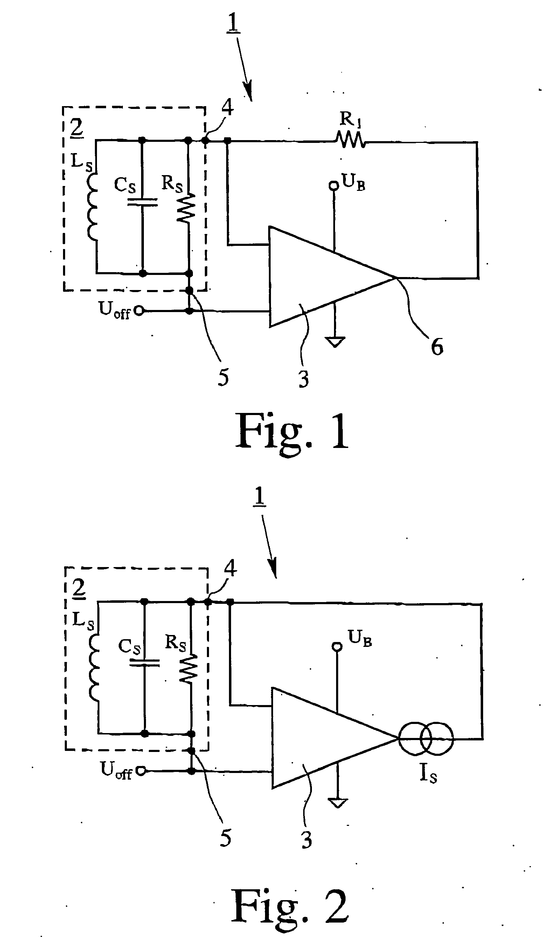

Die Nachteile der in Fig. 5 dargestellten Oszillatorschaltung 1 werden durch die in Fig. 1 dargestellte erfindungsgemäße Oszillatorschaltung weitestgehend vermieden.

Auch hier umfaßt die Oszillatorschaltung 1 einen Schwingkreis 2 und einen Operationsverstärker 3 und der erste Ausgang 4 des Schwingkreises 2 ist mit dem nichtinvertierenden Eingang des Operationsverstärkers 3 verbunden und der zweite Ausgang 5 des Schwingkreises 2 ist mit dem invertierenden Eingang des Operationsverstärkers 3 verbunden. Zusätzlich ist in dem bevorzugten Ausführungsbeispiel nach Fig. 1 lediglich noch der Ausgang 6 des Operationsverstärkers 3 über einen Widerstand R₁ auf den ersten Anschluß des Schwingkreises 2 rückgekoppelt und damit auch elektrisch mit dem nichtinvertierenden Eingang des Operationsverstärkers 3 verbunden. Dargestellt sind ebenfalls die Versorgungsspannungsanschlüsse des Operationsverstärkers 3, wobei ein Anschluß mit der Versorgungsspannung U_{B} und der andere Anschluß mit dem Massepotential der Schaltung verbunden ist.

In einer derartig ausgeführten Oszillatorschaltung wird der Operationsverstärker 3 nicht mehr als Verstärker sondern als Komparator betrieben, da die sich am invertierenden und nicht invertierenden Eingang des Operationsverstärkers 3 einstellende Spannungsdifferenz mit der vollen, dem Operationsverstärker 3 eigenen Verstärkung verstärkt wird und am Ausgang 6 des Operationsverstärkers 3 - begrenzt durch die Betriebsspannung U_{B} - anliegt.

Aufgrund der fehlenden Rückkopplung des Ausgangs 6 auf den invertierenden Eingang des Operationsverstärkers 3 und der Mitkopplung des Ausgangs 6 des Operationsverstärkers wird die ständige Anregung zur Schwingung des Schwingkreises 2 erzwungen; es ist nicht möglich, die elektrische Schwingung des Schwingkreises 2 durch eine noch so große Bedämpfung des Schwingkreises 2 zum Erliegen zu bringen. Diesem Umstand ist es zu verdanken, daß die sonst üblichen, das dynamische Verhalten einer aus dem Stand der Technik bekannten Oszillatorschaltung 1 begrenzenden Anschwingzeiten bei einer erfindungsgemäßen Oszillatorschaltung 1 nicht auftreten. Die erfindungsgemäße Oszillatorschaltung 1 nach Fig. 1 ermöglicht deshalb eine weitaus schnellere, d. h. höherfrequente Erfassung von sich ändernden Beeinflussungszuständen des Schwingkreises 2.

In einem besonders bevorzugten, nicht dargestellten Ausführungsbeispiel werden die üblicherweise mit einer Frequenzgangkorrektur ausgestatteten Operationsverstärker 3 durch solche Operationsverstärker 3 ersetzt, die keine Frequenzgangkorrektur aufweisen. Wie bereits weiter oben ausführlich dargelegt worden ist, weisen solche speziellen Operationsverstärker 3, hier Komparatoren genannt, eine erheblich größere Flankensteilheit beim Umschalten des Ausgangs auf, wodurch eine nochmalige Verbesserung des dynamischen Verhaltens der erfindungsgemäßen Oszillatorschaltung 1 erzielt werden kann.

In einem weiteren bevorzugten Ausführungsbeispiel gemäß einer der Fig. 1 bis 4 ist der invertierende Eingang des Operations- bzw. Komparatorverstärkers 3 mit einer Offsetspannung U_{off} beaufschlagt, die vorzugsweise die Höhe der halben Betriebsspannung U_{B} des Operationsverstärkers 3 aufweist. Dieser Offset bewirkt, daß die elektrische Schwingung des Schwingkreises 2 um die Offsetspannung erfolgen kann. Dies ändert nichts daran, daß nach wie vor durch die erfindungsgemäße Ausführung der Oszillatorschaltung 1 nach einer der Fig. 1 bis 4 aufgrund der Mitkopplung des Ausgangs 6 des Operationsverstärkers 3 eine elektrische Schwingung des Schwingkreises 2 erzwungen wird.

Fig. 2 zeigt ein weiteres bevorzugtes Ausführungsbeispiel der erfindungsgemäßen Oszillatorschaltung 1, bei dem der Rückkopplungswiderstand R₁ entfällt, dafür aber in dem Mitkopplungszweig eine Stromquelle Iₛ, insbesondere eine spannungsgesteuerte Stromquelle I_{S}, verwendet wird. Diese Maßnahme beruht auf der Erkenntnis, daß die Empfindlichkeit der Schaltung nach Fig. 1 mit größer werdendem Wert des Rückkopplungswiderstandes R₁ zunimmt, dafür aber gleichzeitig die Amplitude des Rückkopplungskreises begrenzt wird. Um diesem Effekt entgegenzuwirken kann die Stromquelle I_{S}, wie in Fig. 2 dargestellt, zur Ansteuerung des Schwingkreises 2 verwendet werden.

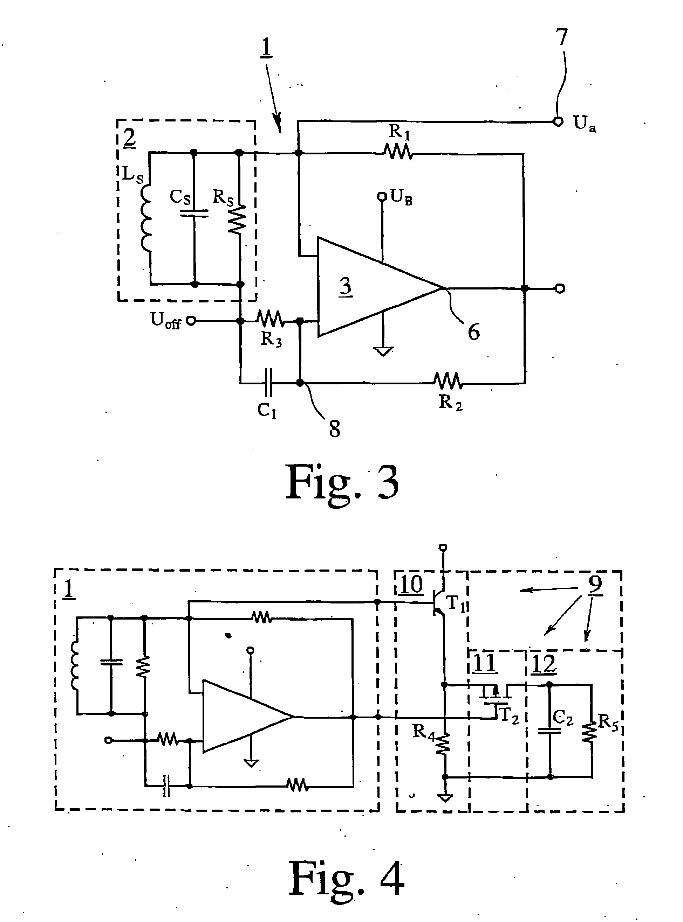

Wie bereits oben ausgeführt worden ist, wird der Schwingkreis 2 bei der erfindungsgemäßen Oszillatorschaltung 1 zwangsläufig und bei jedem Beeinflussungszustand zu einer elektrischen Schwingung angeregt. Wenn auch nicht für den normalen Betrieb, so ist es doch bei einer neuen Inbetriebnahme der erfindungsgemäßen Oszillatorschaltung 1 denkbar, daß der nichtinvertierende Eingang des Operationsverstärkers 3 auf einem niedrigeren Potential liegt als der invertierende Eingang des Operationsverstärkers 3. In diesem Fall wird auf den Schwingkreis wiederum eine negative Ausgangsspannung, die am Ausgang 6 des Operationsverstärkers 3 anliegt, rückgekoppelt, wodurch der Schwingkreis 2 aber nicht zur Schwingung angeregt wird; vielmehr verbleibt die Schaltung in diesem statischen Zustand. Um dies zu vermeiden, wird die erfindungsgemäße Oszillatorschaltung 1 nach Fig. 3 mit einer "Anschwinghilfe" versehen, die darin besteht, daß zwischen dem Ausgang 6 des Operationsverstärkers 3 und dem zweiten Anschluß 5 des Schwingkreises 2 ein ohmscher Spannungsteiler, bestehend aus den Widerständen R₂ und R₃ vorgesehen ist, und der Mittelabgriff 8 des Spannungsteilers R_{2,} R₃ mit dem invertierenden Eingang des Operationsverstärkers 3 verbunden ist und der Zweig des Spannungsteilers R_{2,} R₃ zwischen dem Mittelabgriff 8 und dem zweiten Anschluß 5 des Schwingkreises 2 über einen Kondensator C₁ wechselstrominäßig kurzgeschlossen ist.

Für den oben beschriebenen Fall, daß der Schwingkreis 2 keine elektrischen Schwingungen ausführt, die Schaltung also nur Gleichgrößen aufweist, ist der Spannungsteiler R₂, R₃ voll wirksam, mit dem Ergebnis, daß die negative Spannung am Ausgang 6 des Operationsverstärkers das Potential am invertierenden Eingang des Operationsverstärkers 3 unter das Potential zieht, das schlechtestenfalls an dem nichtinvertierenden Eingang des Operationsverstärkers 3 anliegen kann, wobei die dort anliegende Spannung durch den durch die Widerstände R₁ und R₅ gebildeten Spannungsteiler bestimmt wird.

Für den Fall, daß die erfindungsgemäße Oszillatorschaltung 1 nach Fig. 3 schwingt, stellt der Kondensator C₁ einen wechselstrommäßigen Kurzschluß dar, weshalb der aus den Widerständen R₂ und R₃ gebildete Spannungsteiler nicht mehr wirksam ist und der zweite Anschluß 5 des Schwingkreises 2 direkt, nämlich über den Kondensator C₁, mit dem invertierenden Anschluß des Operationsverstärkers 3 verbunden ist, wie es auch die Schaltungen nach den bevorzugten Ausführungsbeispielen in den Fig. 1 und 2 vorsehen.

Das erfindungsgemäße Ausführungsbeispiel nach Fig. 4 zeigt eine Anwendung der erfindungsgemäßen Oszillatorschaltung 1, wie sie häufig in kontaktlosen Sensoren zu finden ist. Der Oszillatorschaltung 1 ist hier eine Demodulatorschaltung 9 nachgeschaltet, deren Aufgabe darin besteht, aus der amplitudenmodulierten Schwingung des Schwingkreises 2 die Hüllkurve - also die eigentliche durch den Schwingkreis gewonnene Beeinflussungsinformation - zurückzugewinnen.

Nach dem Ausführungsbeispiel in Fig. 4 sieht die Demodulatorschaltung 9 dazu einen Impedanzwandler 10, einen elektronischen Schalter 11 und einen Tiefpass 12 vor. Der Eingang des Impedanzwandlers 10 ist dabei mit dem analogen Ausgang 7 der Oszillatorschaltung 1 verbunden und der elektronische Schalter 11 wird durch das binäre Signal am Ausgang 6 des Operationsverstärkers 3 betätigt, so daß im geschlossenen Zustand des elektronischen Schalters 11 das Ausgangssignal des Impedanzwandlers 10 auf den Eingang des Tiefpasses 12 geführt wird.

Dadurch, daß das Ausgangssignal am Ausgang 6 des Operationsverstärkers präzise einen Vorzeichenwechsel in der Schwingung des Schwingkreises 2 anzeigt und der elektronische Schalter 11 praktisch verzögerungsfrei auf diesen Vorzeichenwechsel reagiert, wirkt der Schalter 11 wie ein Synchrongleichrichter, wodurch die in Fig. 4 gezeigte elegante Implementierung eines Demodulators möglich ist.

In dem in Fig. 4 dargestellten Ausführungsbeispiel ist der Impedanzwandler 10 durch eine Emitterfolgerschaltung T₁, R₄ realisiert, der elektronische Schalter 11 durch einen MOS-Feldeffekttransistor T₂ und der Tiefpass 12 durch ein RC-Glied R₅, C₂.

## Patentansprüche

1. Oszillatorschaltung für einen Sensor, mit einem Schwingkreis (2) und einem Operationsverstärker (3), wobei die elektrische Schwingung des Schwingkreises (2) zwischen einem ersten Anschluß (4) und einem zweiten Anschluß (5) des Schwingkreises (2) abgreifbar ist und der erste Anschluß (4) des Schwingkreises (2) mit dem nichtinvertierenden Eingang des Operationsverstärkers (3) verbunden ist und der Ausgang (6) des Operationsverstärkers (3) auf den nichtinvertierenden Eingang des Operationsverstärkers rückgekoppelt ist,
**dadurch gekennzeichnet,**
**daß** der zweite Anschluß (5) des Schwingkreises (2) - zumindest wechselspannungsmäßig - mit dem invertierenden Eingang des Operationsverstärkers (3) direkt verbunden ist.

2. Oszillatorschaltung nach Anspruch 1, **dadurch gekennzeichnet, daß** der Operationsverstärker (3) als ein spezieller Komparatorverstärker 3 ausgeführt ist, insbesondere keine Korrektur des Frequenzgangs aufweist.

3. Oszillatorschaltung nach Anspruch 1 oder 2, **dadurch gekennzeichnet, daß** der zweite Anschluß (5) des Schwingkreises (2) mit einer Offsetspannung U_{off} im Bereich der Betriebsspannung U_{B} des Operationsverstärkers (3) beaufschlagt ist und die Offsetspannung U_{off} insbesondere die Höhe der halben Betriebsspannung U_{B} des Operationsverstärkers aufweist.

4. Oszillatorschaltung nach einem der Ansprüche 1 bis 3, **dadurch gekennzeichnet, daß** der Ausgang (6) des Operationsverstärkers (3) über einen Widerstand R₁ auf den nichtinvertierenden Eingang des Operationsverstärkers (3) rückgekoppelt ist.

5. Oszillatorschaltung nach einem der Ansprüche 1 bis 3, **dadurch gekennzeichnet, daß** der Ausgang des Operationsverstärkers (6) über eine vorzugsweise spannungsgesteuerte Stromquelle Iₛ auf den nichtinvertierenden Eingang des Operationsverstärkers (3) rückgekoppelt ist.

6. Oszillatorschaltung nach einem der Ansprüche 1 bis 5, **dadurch gekennzeichnet, daß** der erste Anschluß (4) des Schwingkreises (2) einen analogen Ausgang (7) der Oszillatorschaltung darstellt.

7. Oszillatorschaltung nach einem der Ansprüche 1 bis 6, **dadurch gekennzeichnet, daß** zwischen dem Ausgang (6) des Operationsverstärkers (3) und dem zweiten Anschluß (5) des Schwingkreises (2) ein ohmscher Spannungsteiler R₂, R₃ vorgesehen ist, der Mittelabgriff (8) des Spannungsteilers (R₂, R₃) mit dem invertierenden Eingang des Operationsverstärkers (3) verbunden ist und der Zweig des Spannungsteilers (R₂, R₃) zwischen dem Mittelabgriff (8) und dem zweiten Anschluß (5) des Schwingkreises (2) über einen Kondensator C₁ wechselstrommäßig kurzgeschlossen ist.

8. Oszillatorschaltung nach einem der Ansprüche 1 bis 7, **dadurch gekennzeichnet, daß** der Oszillatorschaltung eine Demodulatorschaltung (9) mit einem Impedanzwandler (10), einem elektronischen Schalter (11) und einem Tiefpass (12) nachgeschaltet ist, daß der Eingang des Impedanzwandler (10) mit dem analogen Ausgang (7) der Oszillatorschaltung verbunden ist, daß der elektronische Schalter (11) durch den Ausgang (6) des Operationsverstärkers (3) betätigbar ist und daß im geschlossenen Zustand des elektronischen Schalters (11) das Ausgangssignal des Impedanzwandlers (10) auf den Eingang des Tiefpasses (12) geführt ist.

9. Oszillatorschaltung nach Anspruch 8, **dadurch gekennzeichnet, daß** der Impedanzwandler (10) durch eine Emitterfolgerschaltung T₁, R₄, der elektronische Schalter (11) durch einen MOS-Feldeffekttransistor T₂ und der Tiefpass (12) durch ein RC-Glied R₅, C₂ realisiert ist.

10. Sensor, insbesondere ein induktiver, kapazitiver oder optoelektronischer Näherungssensor, **gekennzeichnet durch** eine Oszillatorschaltung nach einem der Ansprüche 1 bis 9.
